**Europäisches Patentamt**

**European Patent Office**

**Office européen des brevets**

(11) Veröffentlichungsnummer: **0 044 553**
**A1**

## (12) EUROPÄISCHE PATENTANMELDUNG

(21) Anmeldenummer: **81105702.5**

(22) Anmeldetag: **20.07.81**

(51) Int. Cl.³: **H 01 L 21/312**

(30) Priorität: **23.07.80 DE 3027941**

(43) Veröffentlichungstag der Anmeldung:
**27.01.82 Patentblatt 82/4**

(84) Benannte Vertragsstaaten:
**BE DE FR GB IT LU NL**

(71) Anmelder: **SIEMENS AKTIENGESELLSCHAFT Berlin
und München
Postfach 22 02 61
D-8000 München 22(DE)**

(72) Erfinder: **Bierhenke, Hartwig, Dipl.-Ing.
Riemer-Schmidt-Strasse 10
D-8018 Grafing(DE)**

(72) Erfinder: **Birkle, Siegfried, Dr.
Veit-Stoss-Strasse 46
D-8552 Höchstadt a.d. Aisch(DE)**

(72) Erfinder: **Rubner, Roland, Dr.
Buchenring 15
D-8551 Röttenbach(DE)**

(54) Verfahren zum Herstellen von Reliefstrukturen aus Doppellackschichten für integrierte Halbleiterschaltungen, wobei zur Strukturierung hochenergetische Strahlung verwendet wird.

(57) Die Doppellackschicht (2,3) besteht aus einer nicht-vernetzbaren oder durch Strahlung abbaubaren und in dem angewandten Strahlendosisbereich wenig empfindlichen dickeren, unteren Lackschicht (2) und einer oberen, dünneren hochempfindlichen Negativ-Lackschicht (3). Das Verfahren wird verwendet zur Herstellung von integrierten Halbleiterschaltungen im Submikronbereich.

FIG·2

EP 0 044 553 A1

SIEMENS AKTIENGESELLSCHAFT
Berlin und München

Unser Zeichen
VPA
80 P 7 1 1 3 E

Verfahren zum Herstellen von Reliefstrukturen aus Doppellackschichten für integrierte Halbleiterschaltungen, wobei zur Strukturierung hochenergetische Strahlung verwendet wird.

Die vorliegende Patentanmeldung betrifft ein Verfahren zum Herstellen von Reliefstrukturen aus Doppellackschichten, insbesondere auf bereits Reliefstrukturen für integrierte Halbleiterschaltungen aufweisenden Substraten, wobei zur Strukturierung hochenergetische Strahlung wie Korpuskular- oder Photonen-Strahlung verwendet wird.

Der Erfindung liegt die Aufgabe zugrunde, Lackstrukturen im Submikronbereich auf Substraten mittels der Elektronen-, Ionen- oder Röntgenstrahl-Lithographie zu erzeugen, wobei

a) eine maßgetreue Strukturabbildung über die gesamte mit dem Elektronen- oder Ionenstrahl zu beschreibende oder generell zu bestrahlende Fläche, vor allem den bis 1 /um hohen Kanten der bereits auf dem Substrat vorhandenen Reliefstrukturen gewährleistet ist. Hierfür ist Voraussetzung, daß die durch den Belackungsvorgang naturgemäß auftretende unterschiedliche Lackdickenverteilung im Kantenbereich nicht die Lackauflösung beeinflußt wie auch die vom Substrat in unterschiedlich dicke Lackbereiche rückgestreuten Elektronen,

b) möglichst nur ein Entwickler zur Strukturierung der Doppellackschicht verwendet wird,

c) die Reliefkanten mit für nachfolgende Ätzprozesse sicher ausreichender Menge an Resistmaterial abgedeckt sind

Edt 1 Plr/21.7.1980

und

c) die Resist(Lack)strukturen mit kurzer Schreibzeit,
d. h. hohem Durchsatz an Scheiben hergestellt werden
können.

Um auf bereits etwa 1 /um hohe Reliefstrukturen aufweisenden Substraten weitere Strukturebenen aufbauen zu können, war es bisher notwendig, die Substrate so dick mit einem Negativ-Resistmaterial zu beaufschlagen, daß auch die steilen Kanten genügend dick mit Resistmaterial bedeckt waren, um nach dem Bestrahlungs- und Entwicklungs-Prozeß für nachfolgende Ätzprozesse ausreichend maskiert zu sein. Die Folge sind unterschiedlich dicke Lackbereiche auf der Scheibe, wobei die Kanten am dünnsten mit Lack belegt sind. Dies wirkt sich dann bei der Bestrahlung mit hochenergetischen Korpuskeln oder Photonen, insbesondere mit Elektronen in zweifacher Hinsicht negativ auf die Reststrukturauflösung aus. Sowohl der in das Resistmaterial eindringende Elektronenstrahl wie auch der am Substrat erheblich rückgestreute reduzieren mit zunehmender Lackdicke erheblich das Resistauflösungsvermögen. Somit wird die Grenze eines auf ebenen Substraten aufgebrachten und in diesem Fall Submikronstrukturen auflösenden Resists unter Umständen weit in den Mikronbereich verschoben.

Eine Doppel-Lackstruktur der eingangs genannten Art sowie ihre Verwendung ist auch aus der DE-OS 26 55 455 (= US-PS 4 024 293) zu entnehmen. Dabei sollen mindestens zwei aus durch Bestrahlung chemisch abbaubaren Polymeren bestehende Schichten von chemisch so unterschiedlichen Materialien auf ein Substrat aufgebracht werden, daß jede Schicht entwickelt werden kann, ohne daß dabei die andere bzw. die anderen Schichten wesentlich angegriffen werden. Die Herstellung der Lackstruktur geschieht dabei so, daß die Lackstruktur durch eine Maske, die das gewünschte Muster wiedergibt, mit einer Strahlung bestimmter Energie und

0044553

Intensität bestrahlt wird, daß dann beginnend mit der obersten Schicht der Reihe nach alle Schichten entwickelt werden und nach jedem Entwicklungsschritt gespült wird. Die oberste Schicht ist bevorzugt eine Schicht aus reinem Polymethylmethacrylat (PMMA), eine Positiv-Lackschicht. Die bekannte Doppel-Lackstruktur wird bei der Herstellung integrierter Halbleitschaltungen beim sogenannten Metall-Abhebeverfahren (Lift-off-process) verwendet und soll auch eine ungenügende Kantenabdeckung und eine ungleichmäßige Strukturierung im Submikronbereich vermeiden.

Die Nachteile des bekannten Verfahrens bestehen darin, daß

a) die obere Positiv-Lackschicht vergleichsweise unempfindlich ist,

b) für den gesamten Strukturierungsprozeß verschiedene, den Prozeß unrationell gestaltende Entwickler oder Lösungsmittel verwendet werden müssen und

c) die Einstellung der Entwicklungsbedingungen sehr kritisch sind.

Die Erfindung vermeidet diese Nachteile und löst die oben gestellte Aufgabe durch ein Verfahren der eingangs genannten Art dadurch, daß eine Doppel-Lackschicht auf das Substrat aufgebracht wird, bei der die auf dem Substrat direkt aufgebrachte untere Schicht aus einer nicht vernetzbaren oder durch Strahlung abbaubaren und in dem angewandten Strahlendosisbereich wenig empfindlichen Lackschicht besteht und die obere, im Verhältnis um mindestens den Faktor 2 zur unteren Lackschicht dünnere Schicht aus einem hochempfindlichen Negativ-Lack besteht, daß die gewünschten Reliefstrukturen in der Negativ-Lackschicht erzeugt werden und daß die von der Negativ-Lackmaske nicht bedeckten Teile der unteren Lackschicht auf chemischem oder physikalischem Wege entfernt werden.

Weitere vorteilhafte Ausgestaltungen des erfindungsgemäßen Verfahrens ergeben sich aus den Unteransprüchen.
Eine besondere Weiterbildung des Erfindungsgedankens ist
darin zu sehen, daß nach der Bestrahlung der oberen
Negativ-Lackschicht die unbestrahlten Bereiche und die
darunterliegenden Bereiche der unteren Lackschicht mit
dem gleichen Entwickler gelöst werden. Durch die Verwendung nur eines Entwicklers zur Strukturierung sowohl
des Negativ-Resists als auch des darunterliegenden abbaubaren Positiv-Resists bzw. des praktisch strahlungsunempfindlichen Thermoplasten gestaltet sich das erfindungsgemäße Verfahren besonders prozeßvereinfachend
und rationell.

Im folgenden wird anhand von Ausführungsbeispielen und
der Figuren 1 bis 3 das Verfahren nach der Lehre der Erfindung noch näher erläutert. Dabei zeigt die

Figur 1 im Schnittbild eine Anordnung, bei der die nichtmaskierte zweite Schicht durch Nassätzen entfernt
wurde, die

Figur 2 eine Anordnung, bei der reaktives Sputterätzen
angewandt wurde und die

Figur 3 eine Anordnung, bei der die Teile der unteren
Lackschicht gleichzeitig mit der Entwicklung der
unbestrahlten Bereiche der oberen Negativ-Lackschicht entfernt wurden.

Für gleiche Teile wurden gleiche Bezugszeichen verwendet:
Das Substrat ist mit 1, die untere, dickere Lackschicht
mit 2 und die obere, dünnere Negativ-Lackschicht mit 3
bezeichnet. Die untere Lackschicht, welche bezüglich
ihrer Dicke den zu erzeugenden Strukturen angepaßt sein soll, weist eine Schichtdicke im Bereich von 0,2 bis 3 $\mu$m, vorzugsweise 1 $\mu$m auf, die obere Negativ-Lackschicht eine Schichtdicke von 0,1 bis 1,0 $\mu$m, vorzugsweise 0,2 $\mu$m. Die Empfindlichkeit der Negativ-Lackschicht, welche vorzugsweise aus einem Copolymeren aus Glycidylmethacrylat und Styrol besteht, liegt bei 0,4 $\mu$C/cm$^2$, die der unteren Lackschicht, welche vorzugsweise aus Polymethylmethacrylat (PMMA) besteht, liegt bei 50 $\mu$C/cm$^2$.

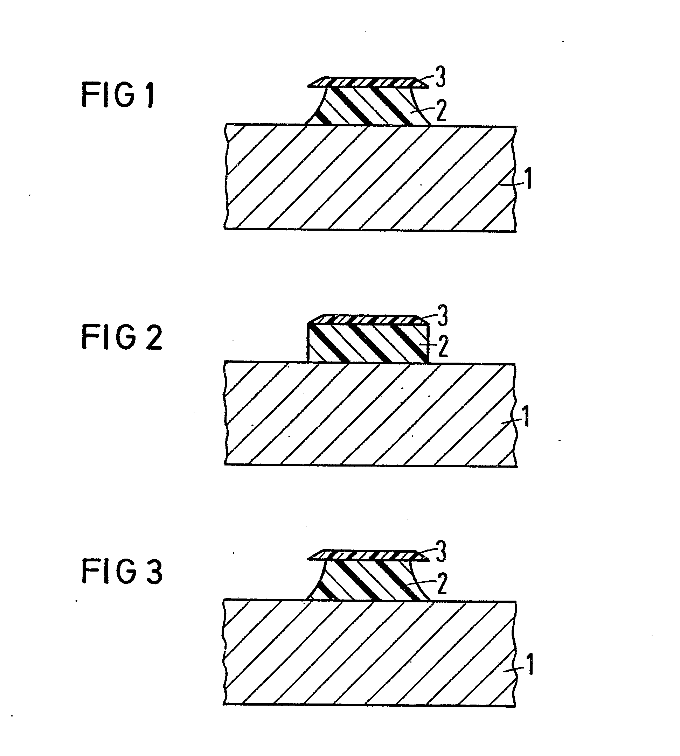

Bei der in Figur 1 dargestellten Anordnung erfolgte das Entfernen der unteren Lackschicht 2 nach Belichtung und Entwicklung der oberen Lackschicht 3 auf naßchemischem Wege durch ein organisches Lösungsmittel, vorzugsweise Methylisobutylketon oder ein Gemisch von Methylisobutylketon mit Äthanol bzw. Isopropanol.

Bei der in Figur 2 dargestellten Anordnung wurde ein Trockenätzverfahren angewandt. Dabei wurden in einem Plasmareaktor bei einem Sauerstoffpartialdruck von 0,7 mbar mit einer Energie von 1000 W die freiliegenden Bereiche der unteren Lackschicht 2 nach Belichtung und Entwicklung der oberen Lackschicht 3 von dem Substrat 1 entfernt. Durch diese Art des Ätzens erhält man, wie aus Figur 2 zu ersehen ist, eine maßgetreue Abbildung, d. h. ohne Unterschneidung der Lackmaskenstrukturen.

Besonders prozeßvereinfachend ist die Strukturerzeugung dann, wenn wie in der in Figur 3 dargestellten Anordnung nach der Bestrahlung der oberen Negativ-Resistschicht 3 die unbestrahlten Bereiche und die untenliegenden Bereiche der PMMA-Schicht 2 im gleichen Entwickler löslich sind. Ein solcher Entwickler ist für den genannten Fall beispielsweise Methyläthylketon oder Methylisobutylketon, gegebenenfalls im Gemisch mit Äthanol oder Isopropanol.

11 Patentansprüche

3 Figuren

<u>Patentansprüche.</u>

1. Verfahren zum Herstellen von Reliefstrukturen aus Doppellackschichten insbesondere auf bereits Reliefstrukturen für integrierte Halbleiterschaltungen aufweisenden Substraten, wobei zur Strukturierung hochenergetische Strahlung wie Korpuskular- oder Photonen-Strahlung verwendet wird, d a d u r c h g e k e n n - z e i c h n e t , daß eine Doppellackschicht auf das Substrat aufgebracht wird, bei der die auf dem Substrat direkt aufgebrachte untere Schicht aus einer nicht vernetzbaren oder durch Strahlung abbaubaren und in dem angewandten Strahlendosisbereich wenig empfindlichen Lackschicht besteht und die obere, im Verhältnis um mindestens den Faktor 2 zur unteren Lackschicht dünnere Schicht aus einem hoch empfindlichen Negativ-Lack besteht, daß die gewünschten Reliefstrukturen in der Negativlackschicht erzeugt werden und daß die von der Negativlackmaske nicht bedeckten Teile der unteren Lackschicht auf chemischem oder physikalischem Wege entfernt werden.

2. Verfahren nach Anspruch 1, d a d u r c h g e - k e n n z e i c h n e t , daß die Negativ-Lackschicht in einer Schichtdicke im Bereich von 0,1 bis 1,0 $\mu$m und die untere Lackschicht in einer Schichtdicke im Bereich von 0,2 bis 3,0 $\mu$m aufgebracht wird.

3. Verfahren nach Anspruch 1 und 2, d a d u r c h g e k e n n z e i c h n e t , daß die nicht von der Negativ-Lackmaske bedeckten Teile der unteren Lackschicht durch reaktives Sputterätzen entfernt werden.

4. Verfahren nach Anspruch 1 und 2, d a d u r c h g e k e n n z e i c h n e t , daß die nicht von der Negativ-Lackmaske bedeckten Teile der unteren Lackschicht gleichzeitig mit der Entwicklung der unbestrahlten Bereiche der Negativ-Lackschicht entfernt werden.

5. Verfahren nach Anspruch 1 bis 4, d a d u r c h  g e k e n n z e i c h n e t , daß als Entwickler Methyläthylketon oder Methylisobutylketon, gegebenenfalls ein Gemisch mit Äthanol oder Isopropanol verwendet wird.

6. Verfahren nach Anspruch 1 bis 5, d a d u r c h  g e k e n n z e i c h n e t , daß als untere Schicht eine, aus einem gegen Korpuskular- oder Photonenstrahlung empfindlichen abbaubaren Positiv-Lack bestehende Schicht verwendet wird.

7. Verfahren nach Anspruch 1 bis 6, d a d u r c h  g e k e n n z e i c h n e t , daß als obere Schicht eine Negativ-Lackschicht mit einer Empfindlichkeit $< 5 \mu C/cm^2$ und als untere Schicht eine durch Strahlung abbaubare Positiv-Lackschicht mit einer Empfindlichekti von 10 bis 100 $\mu C/cm^2$ verwendet wird.

8. Verfahren nach Anspruch 1 bis 5, d a d u r c h  g e k e n n z e i c h n e t , daß als untere Schicht thermoplastische bei niedrigen Strahlendosen nicht vernetzbare Lacke, die frei von -CH- Partialstrukturen sind, verwendet werden.

9. Verfahren nach Anspruch 1 bis 8, d a d u r c h  g e k e n n z e i c h n e t , daß als untere Schicht folgende an sich bekannte Materialien verwendet werden: Polyphenylenoxid, Polyäthersulfone, Polycarbonat, Polymethacrylimid, Novolack/Diazochinon-Gemische, Polyolefinsulfone wie Polybuten-1-sulfon und cyclische Polyolefinsulfone, Polystyrolsulfone, Polyalkylmethacrylate, insbesondere Polymethylmethacrylat (PMMA) und Copolymere von Methylmethacrylat mit $\alpha$-Cl- bzw. $\alpha$-CN-Acrylaten bzw. mit Methacrylnitril, Polymethacrylat mit fluorierter Esterkomponente, Polybenzylmethacrylester, Polymethylisopropenylketon, Polyisobutylen und Copolymere, $\alpha$-Cyanoäthyl-

acrylat- $\alpha$ -Amidoäthylacrylat-Copolymer.

10. Verfahren nach Anspruch 1 bis 9,    d a d u r c h
g e k e n n z e i c h n e t ,    daß als obere Negativ-
Lackschicht folgende an sich bekannte Materialien verwendet werden:
Glycidylmethacrylat, Copolymere aus Glycidylmethacrylat
(Glycidylacrylat) und Styrol bzw. Äthylacrylat, epoxidiertes Butadien bzw. Isopren, Polyacrylamide, Polyvinylchlorid, Polysiloxane, cyclisiertes Polyisopren/Diazid-Gemisch (KTFR), Polystyrol, Polyvinylcarbazol,
halogeniertes Polystyrol und Polyvinylcarbazol, chlormethyliertes Polystyrol, cyclisiertes Polyisopren/Diazid-Gemisch (KMER), Methylmethacrylat-Äthylacrylat-
Glycidylmethacrylat-Terpolymer, partiell verestert mit
Methacrylsäure (CER).

11. Verfahren nach Anspruch 1 bis 9,    d a d u r c h
g e k e n n z e i c h n e t ,    daß als Negativ-Lackschicht strahlungsreaktive Vorstufen hochwärmebeständiger
Polymere wie beispielsweise in der DE-PS 23 08 830 oder
24 37 348 beschrieben, verwendet werden.

1/1

FIG 1

FIG 2

FIG 3

Europäisches
Patentamt

**EUROPÄISCHER RECHERCHENBERICHT**

Nummer der Anmeldung

EP 81 10 5702.5

| | EINSCHLÄGIGE DOKUMENTE | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | WO - A1 - 80/·00639 (WESTERN ELECTRIC) <br> * Ansprüche 1, 2, 6, 7, 14; Seite 6, Zeilen 14 bis 18; Seite 7, Zeilen 25 bis 33; Fig. 5 * <br> -- | 1,3,9 | H 01 L 21/312 |
| | DE - A1 - 2 754 396 (IBM) <br> * Seiten 9 bis 11; Fig. 1B bis 1E * <br> & US - A - 4 092 442 <br> -- | 1-3,10 | |
| | IBM TECHNICAL DISCLOSURE BULLETIN, Band 20, Nr. 11B, April 1978 New York R.A. LESSOR et al. "Negativ E-Beam Lift-Off Process" *Seiten 4765 bis 4766 <br> -- | 1,3,7, 9,10 | RECHERCHIERTE SACHGEBIETE (Int. Cl.³) <br><br> H 01 L 21/312 |
| A | DE - A1 - 2 706 878 (HITACHI et al.) <br> * Ansprüche 8, 9; Seite 9 * <br> ---- | | |

KATEGORIE DER GENANNTEN DOKUMENTE

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patent-familie, übereinstimmendes Dokument

X  Der vorliegende Recherchenbericht wurde für alle Patentansprüche erstellt.

| Recherchenort | Abschlußdatum der Recherche | Prüfer |
|---|---|---|
| Berlin | 15-10-1981 | ROTHER |

EPA form 1503.1  06.78